# EUROPEAN PATENT APPLICATION

(11) **EP 2 584 877 A1**
(43) Date of publication of application: **24.04.2013**
(21) Application number: 11795730.8
(22) Date of filing: 14.06.2011
(51) Int. Cl.: H05K 1/09, H05K 1/03

(54) **SURFACE-ROUGHENED COPPER FOIL AND COPPER-CLAD LAMINATED SUBSTRATE**

(30) Priority: 15.06.2010 JP 2010136153
(71) Applicant: Furukawa Electric Co., Ltd., Chiyoda-ku Tokyo 100-8322 (JP)
(72) Inventor: FUJISAWA, Satoshi, Tokyo 100-8322 (JP)
(74) Representative: Thun, Clemens
(86) International application number: PCT/JP2011/063577
(87) International publication number: WO 2011/158825

(57) **Abstract**

Disclosed is a surface-roughened copper foil that can show excellent adhesion to an anisotropic conductive resin (ACF) and a copper-clad laminate using same. Specifically disclosed is a surface-roughened copper foil which is surface-roughened by surface roughening on at least one surface of a base copper foil (untreated copper foil), wherein the roughening treated surface is finished so that a surface roughness (Ra) of 0.28 µm or more of the adhesion surface of a polyimide film to be adhered to the roughening treated surface.

## Description

### Technical Field

The present invention relates to a surface-treated roughened copper foil which is obtained by roughening a surface of a base copper foil (untreated copper foil). Further, the present invention relates to a copper-clad laminate which is obtained by laminating a polyimide film to a surface-treated roughened copper foil.
In particular, the present invention relates to a surface-treated roughened copper foil having a surface of a base copper foil roughened so that when etching a copper foil of a copper-clad laminate (hereinafter, sometimes described as a "CCL") prepared by laminating a polyimide film to the surface of copper foil to form a circuit board, and laminating an IC chip or the like to this circuit board by using an ACF (anisotropic conductive film) to form circuit parts, resultant adhesiveness between the polyimide film and the ACF is improved.

### Background Art

Patent Literatures (PLT's) 1 and 2 disclose technologies of etching a copper foil of a CCL prepared by laminating a polyimide film to a surface of a copper foil to form a circuit board and bonding an IC chip or the like to this circuit board by using an ACF to prepare circuit parts.

Patent Literature 1 discloses that an adhesiveness between the polyimide and an ACF is improved by adjusting an etching time etc., after laminating the copper foil and the polyimide film to each other, and etching the copper foil, so as to be remained nickel existing on the surface of the copper foil on the polyimide film. However, as described in the later explained Patent Literature 2, in general, if metal remains on a surface portion of a polyimide film after etching a copper foil, the migration resistance characteristic falls. This phenomenon appears more conspicuously as a wiring pitch becomes narrower, so realization may be possible, provided that a line width/space width is 50 µm/50 µm as described in the examples. However, realistically, realization may be impossible if a wiring pitch is 25 µm/25 µm or less which has been demanded in recent years.

Further, in Patent Literature 2, there is defined a shape of the copper foil-roughened surface under the conditions of a surface roughness Rz, a surface area ratio, and a L value in the Lab Colorimetric System of the copper foil-roughened surface. Patent Literature 2 discloses that a replica of the copper foil surface shape produced on a resin side shows an anchoring effect against the ACF and exerts a great influence to the adhesion, with regard of the adhesion against the ACF, the examples find whether or not an initial adhesion satisfies more than 0.4 kN/m. However, the adhesion between the polyimide film and the ACF which has been desired in recent years is generally not an initial adhesion, rather the adhesion after a test for a long time under high temperature and high humidity. An adhesion of 0.6 kN/m or more after the test under the high temperature and high humidity is required, but the technology disclosed in Patent Literature 2 cannot satisfy the adhesion under such a high temperature and high humidity atmosphere.

### Prior Art Documents

### Patent Literatures

PLT 1: Japanese Patent Publication No. 2006-147662 A1
PLT 2: Japanese Patent Publication No. 2009-105286 A1

### Summary of the Invention

### Problems to be solved by the Invention

The inventor intensively studied the adhesiveness between a polyimide film and an ACF, and, as a result, got to reach the technical idea that an adhesiveness between the ACF and the polyimide film, and a high temperature and high humidity resistance thereof might be obtained by forming a certain amount or more of concave (recessed) parts on the polyimide film side to thereby complete the present invention.
An object of the present invention is to provide a surface-treated roughened copper foil capable of obtaining a polyimide surface shape, extremely excellent in adhesion between a polyimide film and an ACF and high temperature and high humidity resistance at an adhered portion.
Further, another object of the present invention is to provide a copper-clad laminate formed by laminating a surface-treated roughened copper foil and a polyimide film, the surface-treated copper foil being capable of obtaining a polyimide surface shape extremely excellent in adhesion between a polyimide film and an ACF and high temperature and high humidity resistance at an adhered portion.

### Means for Overcoming the Problems

A surface-treated roughened copper foil according to the present invention is a surface-treated roughened copper foil in which at least one surface of a base copper foil (untreated copper foil) is formed as a roughened surface by roughening treatment, wherein the roughened surface is finished to have a surface roughness Ra of an adhered surface of a polyimide film to be adhered to the roughened surface, being 0.28 µm or more.

The surface-treated roughened copper foil according to the present invention is roughened on its surface so that a glossiness at an incident angle of 60° to a polyimide film, after laminating the polyimide film to the surface-treated roughened copper foil, and thereafter removal of the copper foil therefrom, becomes less than 1.5.

Preferably, an Ni or Ni alloy layer is formed on the roughened surface of the surface-treated roughened copper foil.
Further, preferably, a Zn or Zn alloy layer is formed on the roughened surface of the surface-treated roughened copper foil, and an anti-rust coating layer made of Cr or a chromate layer is further formed on that layer.

Further, preferably, a silane coupling layer is formed on the roughened surface of the surface-treated roughened copper foil, the surface of the Ni or Ni alloy layer, and the surface of the Cr or chromate layer.

Further, the present invention is a copper-clad laminate obtained by laminating a polyimide film to the surface-treated roughened copper foil.

### Effects of the Invention

The surface-treated roughened copper foil of the present invention has the excellent effect that concave parts excellent in adhesiveness with an ACF can be created on the surface of the polyimide film which is laminated to the copper foil.
Further, the present invention can provide a copper-clad laminate wherein concave parts excellent in adhesiveness with an ACF are created on the surface of the polyimide film which is laminated to the surface-treated roughened copper foil. Description of Embodiments

In the present invention, a base copper foil (untreated copper foil) to be treated on its surface may be any of an electrolytic copper foil, electrolytic copper alloy foil, rolled copper foil, and rolled copper alloy foil. Note that, when it is not necessary to particularly differentiate these foils, the foil will be sometimes simply expressed as a "copper foil" or "base copper foil".
The thickness of the copper foil is preferably 5 µm to 35 µm. This is because if the thickness of the copper foil is thinner than 5 µm, for example, wrinkles are formed at the time of production and the production of thin copper becomes costly, so this is not realistic. Further, if the foil thickness is thicker than 35 µm, such the foil is not preferable, because it becomes out of the specifications for thinness and small size of an IC mounting board etc. used for driving a liquid crystal display of a display part of a personal computer, mobile phone and PDA.

The surface of the copper foil is carried out the roughening treatment to improve the adhesiveness with the polyimide film, and to provide suitable concave parts on the surface of the polyimide film, and, according to need, is further carried out the surface treatment thereon for the purpose of prevention of diffusion or rust prevention of rust. In the present invention, as that surface processes, mainly roughening treatment by copper or copper alloy and surface treatment by Ni or Ni alloy, Zn or Zn alloy, Cr or chromate, silane coupling agent, or other surface treatment, are applied.

In the present invention, first, the roughening treatment by copper or copper alloy is applied to the surface of the base copper foil. The roughening treatment is carried out to obtain convex (protrude) shapes with sharp front ends (for example, roughening particles as a whole have a needle point shape, arrowhead shape, conical shape, mushroom shape, trigonal pyramid shape, or the like, or the portions other than the front ends of the roughening particles have a columnar or square pillar shape and only the front end portions have a needle point shape, arrowhead shape, conical shape, mushroom shape, trigonal pyramid shape or other shape). The reasons for forming the sharp front end convex shapes are that these roughed portions easier penetrate to the surface of the polyimide rather than that with spherical roughened shapes, therefore strong adhesion between the copper foil and the polyimide film is obtained, and, there is obtained strong adhesion between the polyimide film and the ACF by the ACF being filled in the concave parts on the polyimide film surface which are formed by penetration of the polyimide film into the roughened surface.
A layer of polyimide is provided on the roughened surface of the roughened copper foil formed the front ends with convex shapes. The layer of polyimide may be constituted by laminating polyimide films, or may be constituted by coating a liquid-state polyimide on the surface of the copper foil and drying the same to form a film state. Next, the copper foil on the surface of the polyimide film is removed. The surface roughness Ra of the polyimide surface after removal of the copper foil is made 0.28 µm or more, more preferably 0.33 µm or more.

If the surface roughness Ra of the polyimide surface is less than 0.28 µm, an initial adhesion between the polyimide film and the ACF and an adhesion after exposure to a high temperature and high humidity atmosphere become worse.
In the present invention, the roughness which is formed on the surface of the polyimide film is made 0.28 µm or more, preferably 1.00 µm or less. The surface roughness Ra represents a cross-sectional area of the concave parts which are formed on the surface of the polyimide film (magnitude of filling of ACF), if the Ra is greater, it means the greater the amount by which the ACF is filled. The reason is if the amount of filling by the ACF increases, the adhesion between the ACF and film rises along with the increase. However, if such a surface-treated roughened copper foil has the surface roughness Ra of the polyimide surface of 1.00 µm or more, a wiring pitch which is sought in recent years is liable to be unable to be prepared any longer, so this is not preferred.

Further, in the present invention, the glossiness at the incident angle 60°of the film surface after removal of the copper foil on the polyimide film surface is made less than 1.5, more preferably less than 0.8.
If the glossiness of the surface of the polyimide film is 1.5 or more, the initial adhesion between the polyimide film and the ACF and the adhesion after exposure to a high temperature and high humidity atmosphere become worse.
The reason for defining the glossiness of the polyimide surface is that the glossiness of the surface of the polyimide film before laminating with the copper foil is about 160 to about 170 (extent of frosted glass) and the glossiness becomes smaller if the concave parts are formed by the roughening. Unless the roughening is uniformly applied to the surface of the copper foil, portions may be formed which have no concave parts by roughening on the surface of the polyimide film (hereinafter, sometimes expressed as unbonded portions). If such unbonded portions become a greater in number or size, the ACF is not filled there, so the adhesion is not sufficiently obtained between the polyimide film and the ACF. The unbonded portions show the same glossiness as that on the surface of the polyimide film before laminating of the copper foil, therefore the glossiness rises along with increase or broadening of the unbonded portions. In the present invention, more preferably the Ra of the surface of the polyimide film after removal of the copper foil on the polyimide film surface is 0.28 µm or more, and the glossiness at the incident angle 60° is controlled to less than 1.5.

Further, in the present invention, preferably, a coating layer made of Ni or Ni alloy is formed on the roughened surface of the surface-treated roughened copper foil. This is because the Ni or Ni alloy has the effects of improving the initial adhesion between the copper foil and the polyimide film and preventing a drop in the adhesion after exposure to a high temperature and high humidity atmosphere by preventing the copper from diffusing into the polyimide film.

Further, in the present invention, preferably, a coating layer made of Zn or Zn alloy or Cr or a chromate layer is formed on the roughened surface of the surface-treated roughened copper foil. This is because the Zn or Zn alloy and further Cr or chromate layer have the effects of preventing the surface of the copper foil from oxidizing, improving the initial adhesion between the copper foil and the polyimide film, and preventing a drop in adhesion after exposure in a high temperature and high humidity atmosphere.

Further, in the present invention, the roughened surface of the surface-treated roughened copper foil is preferably formed with a coating layer comprised of a silane coupling layer on the surface of the Ni or Ni alloy layer, the surface of the Zn or Zn alloy layer, or the surface of the Cr or chromate layer. This is because the silane coupling layer has the effect of raising the initial adhesion between the copper foil and the polyimide film.

The copper-clad laminate of the present invention naturally may be a single-sided copper-clad laminate which is formed by laminating a copper foil to only one side of a polyimide film and may be a double-sided copper-clad laminate obtained by laminating copper foils to the two sides of polyimide.

The copper-clad laminate of the present invention is prepared by a method of laminating a polyimide film to the roughened surface of the surface-treated roughened copper foil by hot pressing, or a method of coating a liquid-state polyimide onto the surface of the copper foil and drying the same to form a film-state.
The laminate formed by laminating the surface-treated roughened copper foil of the present invention and the polyimide film had a sufficient initial adhesion and adhesion after exposure to a high temperature and high humidity atmosphere, when preparing a circuit of L/S = 25 µm/25 µm by etching and connecting an IC chip by an ACF.

The present invention will be explained in detail with reference to examples. Note that, the measurement of the adhesive strength and the evaluation of samples based on the examples were performed according to the following.
Measuring means and measurement conditions
(1) Calculation of surface roughness Ra of concave parts Measured by a laser microscope (VK8500) made by Keyence Corporation.
(2) Measurement of glossiness
   Measured at a light emitting/receiving angle of 60° by a Gloss Meter (VG2000) made by Nippon Denshoku Industries Co., Ltd.
(3) Measurement of initial adhesion
   It was found by press bonding an IC chip for evaluation use to a polyimide film by an ACF, bonding this evaluation-use IC chip to a support board by a double-sided tape, and peeling off a 1 mm width piece of the polyimide film at a rate of 50 mm/min in a direction at 90 degrees by using a Tensilon Tester (made by Toyo Seiki SeisakuSho, Ltd.)
(4) Measurement of adhesion after high temperature and high humidity test
   The adhesion after an elapse of 200 hours and after an elapse of 1000 hours at a temperature of 80°C and a humidity of 95% were found in the same way the initial adhesion.

### Examples

### Example 1

To one surface of a base copper foil, roughening was carried out at least one time under the following plating bath and plating conditions in the order of the roughening plating 1 and roughening plating 2 to thereby prepare convex shaped roughening particles with sharp front ends.
The roughening plating 1 performs electrolysis with a current density near the limited current density of the following bath, and deposits a copper burnt plating layer comprised of copper particles as roughening particles of shapes of convex shapes with sharp front ends on the surface of the untreated copper foil.
The roughening plating 2 produces a plating layer (so-called "capsule layer") of copper on the burnt plating layer wherein the plating was carried out so that the roughening particles in the roughening plating 1 do not drop off from the surface of the copper foil.

### Roughening plating 1

Copper sulfate (as Cu concentration): 5 to 10 g/L
Sulfuric acid: 30 to 120 g/L
Ammonium molybdate (as Mo concentration): 0.1 to 5.0 g/L
Ferric sulfate (as Fe concentration): 0.1 to 5.0 g/L
Solution temperature: 20 to 60°C
Current density: 10 to 60 A/dm²

### Roughening plating 2

Copper sulfate (as Cu concentration): 20 to 70 g/L
Sulfuric acid: 30 to 120 g/L
Solution temperature: 20 to 65°C
Current density: 5 to 65 A/dm²

To the roughened surface of this surface-treated roughened copper foil, a polyimide film (UPILEX 25VT made by Ube Industries Ltd.) was laminated by hot pressing. After that, the copper foil was removed by an etchant of ferric chloride or cupric chloride, then the surface roughness Ra and the glossiness on the film surface side from which the copper foil was removed were measured. As a result, the surface roughness Ra of the surface of the polyimide film was 0.38 µm, and the glossiness at an incident angle of 60 degrees was 0.6. To this polyimide surface, an IC chip was provisionally pressed by an ACF at 70°C for 2 seconds and pressed at 200°C for 10 seconds, then the adhesion was measured. When measuring the adhesion between this polyimide film and the ACF, the initial adhesion was 1.2 kN/m. When exposing this in a high temperature and high humidity atmosphere for 200 hours or 1000 hours, then returning it to ordinary temperature and measuring the adhesion, the adhesion after exposure for 200 hours was 1.1 kN/m and the adhesion after exposure for 1000 hours was 1.1 kN/m.

### Examples 2 to 4

Samples were produced in the same way as Example 1. The samples in Examples 2 to 4 were adjusted in surface roughness by changing the current density within the range of the plating bath in Example 1. The adjusted surface roughnesses Ra are shown in Table 1.
The initial adhesion and adhesion after the high temperature and high humidity test for 200 hours and after the high temperature and high humidity test for 1000 hours were measured in the same way as Example 1. The results are described together in Table 1.

### Comparative Examples 1 to 4

Samples were produced in the same way as Example 1. The samples in Comparative Examples 1 to 4 were adjusted in surface roughness by changing the current density within the range of the plating bath in Example 1. The adjusted surface roughnesses Ra are shown in Table 1.
The initial adhesion and adhesion after the high temperature and high humidity test for 200 hours and after the high temperature and high humidity test for 1000 hours were measured in the same way as Example 1. The results are described together in Table 1.

**Table 1**

| No. | Polyimide surface | | Adhesion kN/m | | | Overall judgment |
|---|---|---|---|---|---|---|
| | Roughness (Ra) | Glossiness | Initial | After high temperature and high humidity | | |
| | µm | | | 200 h | 1000 h | |
| Example 1 | 0.38 | 0.6 | Very good | Very good | Very good | Very good |
| Example 2 | 0.34 | 0.7 | Very good | Very good | Very good | Very good |
| Example 3 | 0.32 | 0.6 | Very good | Very good | Good | Good |
| Example 4 | 0.29 | 1.1 | Very good | Good | Good | Good |
| Comparative Example 1 | 0.25 | 1.3 | Very good | Poor | Poor | Fair |
| Comparative Example 2 | 0.23 | 2.5 | Good | Poor | Poor | Fair |
| Comparative Example 3 | 0.20 | 6.7 | Poor | Poor | Poor | Poor |
| Comparative Example 4 | 0.26 | 14.1 | Poor | Poor | Poor | Poor |

### Criteria of initial adhesion

Very good: 1.0 kN/m or more
Good: 0.8 kN/m or more
Poor: Less than 0.8 kN/m

### Criteria of adhesion after exposure of high temperature/high humidity

Very good: 0.8 kN/m or more
Good: 0.6 kN/m or more
Poor: Less than 0.6 kN/m

### Criteria of overall judgment

Very good: Everything good
Good: Everything standard value or more
Fair: Item less than standard value exists
Poor : Everything less than standard value

As shown in Table 1, for Examples 1 to 2, the surface roughnesses Ra of the surfaces of the polyimide films were 0.33 µm or more, and the glossinesses were less than 0.8 - both of them within the preferred ranges. Accordingly, the initial adhesion between the polyimide films and the ACF, the adhesion after the high temperature and high humidity test for 200 hours, and the adhesion after the high temperature and high humidity test for 1000 hours were good. (Overall judgment: Very good)

For Example 3, the roughness Ra of the surface of the polyimide film was within the range of the standard value, but the adhesion after the high temperature and high humidity test for 1000 hours was a little bit lower than the particularly preferred range of 0.8 kN/m. (Overall judgment: Good)

For Example 4, the roughness Ra and glossiness of the surface of the polyimide film were within the standard value ranges, but the adhesion after the high temperature and high humidity test for 200 hours and the adhesion after the high temperature and high humidity test for 1000 hours were a bit lower than the particularly preferred range of 0.8 kN/m.

### (Overall judgment: Good)

For Comparative Example 1, the roughness Ra of the surface of the polyimide film was out of the range of the standard value, the glossiness was within the range of the standard value, and the initial adhesion between the polyimide film and the ACF was good, but the adhesion after the high temperature and high humidity test was less than the standard value. (Overall judgment: Fair)

For Comparative Example 2, the roughness Ra and glossiness of the polyimide surface were out of the ranges of the standard values, but the initial adhesion between the polyimide film and the ACF was the standard value or more. However, the adhesion after the high temperature and high humidity test was less than the standard value. (Overall judgment: Fair)

For Comparative Examples 3 to 4, the roughnesses Ra and glossinesses of the polyimide surfaces were out of the ranges of the standard values, and both of the initial adhesion between the polyimide films and the ACF and the adhesion after the high temperature and high humidity test were less than the standard values. (Overall judgment: Poor)

As explained above, the surface-treated roughened copper foil of the present invention satisfies the requirements of the initial adhesion between the polyimide film and the ACF, the adhesion of 200 hours after exposure to a high temperature and high humidity atmosphere, and the adhesion of 1000 hours after exposure to a high temperature and high humidity atmosphere, so this copper foil is an industrially excellent surface-treated roughened copper foil.

## Claims

1. A surface-treated roughened copper foil in which a roughening treated surface is formed on at least one side of a base copper foil (untreated copper foil) by a roughening treatment, wherein the roughening treated surface is finished so that a surface roughness Ra of an adhered surface of a polyimide film to be adhered to the roughening treated surface is 0.28 µm or more.

2. The surface-treated roughened copper foil as set forth in claim 1, wherein a glossiness, at an incident angle of 60° to the polyimide film after laminating the polyimide film to the surface-treated roughened copper foil and then removal of the copper foil therefrom, becomes less than 1.5.

3. The surface-treated roughened copper foil as set forth in claim 1 or 2, wherein an Ni or Ni alloy layer is formed on the roughening treated surface of the surface-treated roughened copper foil.

4. The surface-treated roughened copper foil as set forth in any one of claims 1 to 3, wherein a Zn or Zn alloy layer is formed on the roughening treated surface of the surface-treated roughened copper foil, and an anti-rust coating layer made of Cr or a chromate layer is formed on that layer.

5. The surface-treated roughened copper foil as set forth in any one of claims 1 to 4, wherein a silane coupling layer is formed on the roughening treated surface of the surface-treated roughened copper foil, the surface of the Ni or Ni alloy layer, and the surface of the Cr or chromate layer.

6. A copper-clad laminate is adhered a polyimide film to the surface-treated roughened copper foil as set forth in any one of claims 1 to 5.
